(19) Europäisches Patentamt
European Patent Office
Office européen des brevets

(11) Veröffentlichungsnummer: **0 264 046 B1**

# EUROPÄISCHE PATENTSCHRIFT

(45) Veröffentlichungstag der Patentschrift: **18.12.91**

(21) Anmeldenummer: **87114521.5**

(22) Anmeldetag: **05.10.87**

(51) Int. Cl.⁵: **H04Q 3/52**, H03K 17/693, H03K 3/356

(54) Breitbandsignal-Koppeleinrichtung.

(30) Priorität: **07.10.86 DE 3634154**

(43) Veröffentlichungstag der Anmeldung:
**20.04.88 Patentblatt 88/16**

(45) Bekanntmachung des Hinweises auf die
Patenterteilung:
**18.12.91 Patentblatt 91/51**

(84) Benannte Vertragsstaaten:
**AT BE CH DE FR GB IT LI NL SE**

(56) Entgegenhaltungen:
**DE-A- 3 339 985**

**FERNSEH- & KINO- TECHNIK, Band 38, Nr. 4, 1984, Seiten 137-143, Berlin, DE; J. SCHO- MERS: "Digitales Breitbandkoppelfeld mit ei- ner monolithisch integrierten Koppelmatrix"**

**PATENT ABSTRACTS OF JAPAN, Band 10, Nr. 283 (E-440)[2339], 26. September 1986; & JP-A-61 101 121**

(73) Patentinhaber: **SIEMENS AKTIENGESELL- SCHAFT**
**Wittelsbacherplatz 2**
**W-8000 München 2(DE)**

(72) Erfinder: **Hofmann, Rüdiger, Dr.**
**Fürstenfelder Weg 12**
**W-8031 Gilching(DE)**

**Beschreibung**

Neuere Entwicklungen der Fernmeldetechnik führen zu diensteintegrierenden Nachrichtenübertragungs- u. -vermittlungs-systemen für Schmalband- und Breitband-Kommunikationsdienste, die als Übertragungsmedium im Bereich der Teilnehmeranschlußleitungen Lichtwellenleiter vorsehen, über die sowohl die Schmalbandkommunikationsdienste, wie insbesondere 64-kbit/s-Digital-Telefonie, als auch Breitbandkommunikationsdienste, wie insbesondere 140-Mbit/s-Bildtelefonie, geführt werden, wobei aber in den Vermittlungsstellen (vorzugsweise gemeinsame Steuereinrichtungen aufweisende) Schmalbandsignal-Koppeleinrichtungen und Breitbandsignal-Koppeleinrichtungen nebeneinander vorgesehen sind (DE-PS 24 21 002).

Im Zusammenhang mit einer Breitbandsignal-Zeitmultiplex-Koppeleinrichtung, deren Koppelpunkte im Zeitmultiplex jeweils für eine Mehrzahl von Verbindungen genutzt werden, ist es bekannnt, jeweils zwei Leitungen mit Hilfe eines Gatterelements zu verbinden, das von einer als bistabiles D-Kippglied gebildeten koppelpunktindividuellen Speicherzelle ein- und ausgeschaltet wird, wobei diese koppelpunktindividuelle Speicherzelle, deren Clock-Eingang ein entsprechendes Taktsignal zugeführt wird, in nur einer Koordinatenrichtung, und zwar an ihrem D-Eingang, angesteuert wird (Pfannschmidt: "Arbeitsgeschwindigkeitsgrenzen von Koppelnetzwerken für Breitband-Digitalsignale", Diss., Braunschweig 1978, Bild 6.7, ferner Bild 6.4). In Anbetracht eines bei einer Bitrate von 140 Mbit/s erreichbaren Zeitmultiplexfaktors von etwa 4 bis 8 und der dabei erforderlichen aufwendigen Schaltungstechnologie werden derzeit allerdings zur Vermittlung von Breitbandsignalen reine Raumkoppeleinrichtungen bevorzugt, in denen die über die einzelnen Koppelpunkte durchgeschalteten Verbindungen allein räumlich voneinander getrennt sind.

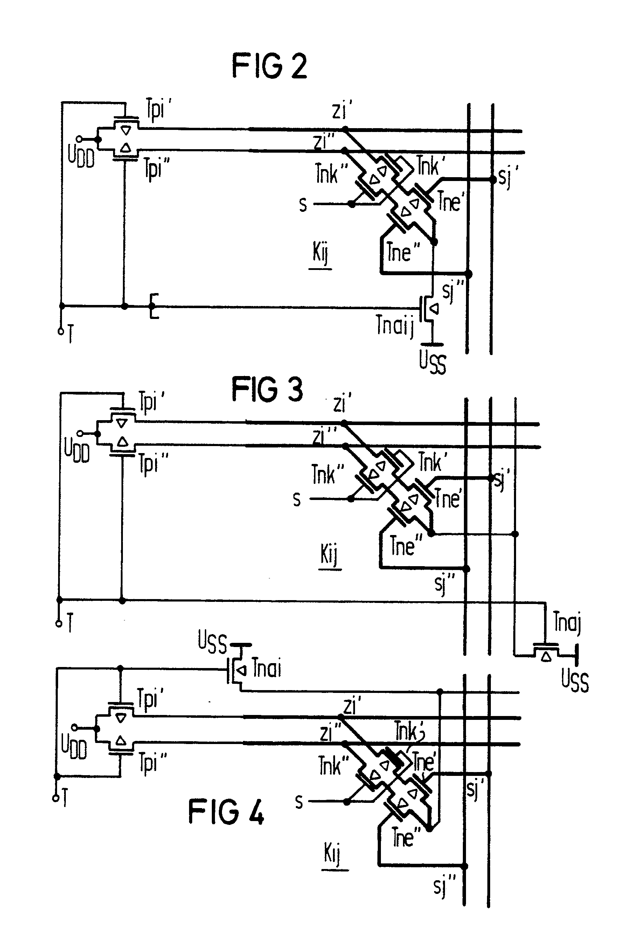

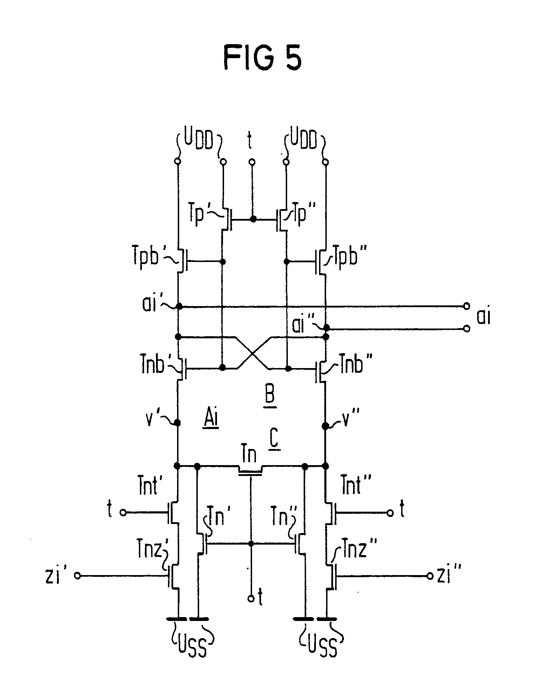

Eine reine Breitbandsignal-Raumkoppelanordnung kann als mit Eingangsverstärkern und Ausgangsverstärkern versehene Koppelpunktmatrix in C-MOS-Technik ausgebildet sein, in deren Koppelpunkten die Koppelelemente jeweils von einem decodergesteuerten, koppelpunktindividuellen Halte-Speicherelement gesteuert werden, wobei die Koppelelemente jeweils als C-MOS-Transfergate (C-MOS-Transmissionsgate) ausgebildet sind (ISS'84 Conference Papers 23C1, Fig.9); die koppelpunktindividuellen Halte-Speicherelemente eines reinen Raumkoppelvielfachs können von einem Zeilendecoder und von einem Spaltendecoder her jeweils über eine zeilen- bzw. spaltenindividuelle Ansteuerleitung in zwei Koordinaten angesteuert werden (Pfannschmidt, a.a.O., Bild 6.4). Umgekehrt ist es aber auch möglich, koppelpunktindividuelle Adressendecoderelemente (Verknüpfungsglieder) in die Koppelpunktmatrix selbst zu integrieren, wobei diese Adressendecoderelemente von externen, d.h. außerhalb der eigentlichen Koppelpunktmatrix angeordneten Adressenregistern her mit den Koppelpunktadressen beaufschlagt werden (s. z.B. Kunze: "TIDES: A New Concept In Time Division Electronic Switching", Communications présentées au COLLOQUE INTERNATIONAL de COMMUTATION ÉLECTRONIQUE, Paris 1966, ÉDITIONS CHIRON, Seiten 301...312, FIG.4 und FIG.5).

Es ist auch (aus EP-A-87 113 203) eine Breitbandsignal-Koppeleinrichtung mit einer KoppelpunktMatrix in FET-Technik, deren Koppelelemente jeweils mit einem an seiner Steuerelektrode mit einem Durchschalte- bzw. Sperrsignal beaufschlagten, mit einer Hauptelektrode an die zugehörige Matrixausgangsleitung angeschlossenen Schalter-Transistor gebildet sind, bekannt, bei der die Koppelelemente jeweils einen mit dem Schalter-Transistor eine Serienschaltung bildenden Vorschalt-Transistor aufweisen, der mit seiner Steuerelektrode an die zugehörige Matrixeingangsleitung angeschlossen ist und dessen der Serienschaltung abgewandte Hauptelektrode über einen Abtast-Transistor mit dem einen Anschluß der Betriebsspannungsquelle verbunden ist, mit deren anderen Anschluß die jeweilige Matrixausgangsleitung über einen Vorlade-Transistor verbunden ist, und bei der Vorlade-Transistor und Abtast-Transistor gegensinnig zueinander jeweils an ihrer Steuerelektrode mit einem eine Bit-Durchschaltezeitspanne in eine Vorladephase und die eigentliche Durchschaltephase unterteilenden Koppelfeld-Ansteuer-Takt beaufschlagt sind, so daß in jeder Vorphase bei gesperrtem Abtast-Transistor die Matrixausgangsleitung über den Vorlade-Transistor zumindest angenähert auf das an dem genannten anderen Anschluss der Betriebsspannungsquelle herrschende Potential geladen wird.

Des weiteren ist (aus FERNSEH- UND KINO-TECHNIK 38(1984)4, 137...143, Bild 3 bis Bild 5,) eine Breitbandsignal-Koppeleinrichtung mit einer Koppelpunktmatrix in ECL-Technik bekannt, die jeweils mit zwei Signalleitern gebildete Matrixeingangsleitungen aufweist, welche einerseits jeweils an zwei Komplementärausgänge eines Zeilen-Eingangsverstärkers angeschlossen sind und andererseits über Koppelpunkte mit ebenfalls jeweils mit zwei Signalleitern gebildeten Matrixausgangsleitungen verbindbar sind, welche jeweils zu den beiden Signaleingängen eines durch einen Differenzverstärker gebildeten Spalten-Ausgangsverstärkers führen. Dabei sind die Koppelpunkte in einer (auch als CML - Current Mode Logic bezeichneten) bipolaren Stromschaltertechnik ausgeführt, derzufolge ein von einer durch ein Durchschalte- bzw. Sperrsignal schaltbaren Stromquelle gelieferter Strom nach Maßgabe des Matrix-Eingangssignals in den einen oder in den anderen Zweig eines mit zwei emittergekoppelten Transistoren gebildeten Differenzverstärkers geschaltet wird; durch eine zwei zusätzliche Transistoren genau der gleichen Abmessungen erfordernde Neutralisationsschaltung sind dabei störende Signale zu dämpfen, die im Sperrzustand eines solchen Koppelpunkts über die Sperrschichtkapazität der Kollektor-Basis-Dioden zum Ausgang gelangen können.

Läßt sich die ECL-Technik durch Eigenschaften wie hohe Arbeitsgeschwindigkeit, (mittel-)hoher Integrationsgrad und (mittel-)hohe Verlustleistung charakterisieren, so zeichnet sich die FET-Technik - bei demgegenüber allerding nur mittleren Arbeitsgeschwindigkeiten - durch einen sehr hohen Integrationsgrad und sehr niedrige Verlustleistungen aus. Diese letzteren Eigenschaften führen zu dem Bemühen, mit integrierten Schaltungen in FET-Technik auch in bislang der Bipolar-Technik vorbehaltene Geschwindigkeitsbereiche vorzudringen. Die Erfindung stellt sich nun die Aufgabe, einen die ECL-Technik umgehenden Weg zu einer Breitbandsignal-Koppeleinrichtung besonders hoher Arbeitsgeschwindigkeit bei zugleich hoher Integrationsfähigkeit und niedriger Verlustleistung aufzuzeigen.

Die Erfindung betrifft eine Breitbandsignal-Koppeleinrichtung mit einer Koppelpunktmatrix, die jeweils mit zwei Signalleitern gebildete Matrixeingangsleitungen aufweist, die einerseits jeweils mit ihren beiden Signalleitern an zwei Differenz-(Komplementär-)ausgänge einer Eingangsdigitalsignalschaltung angeschlossen sind und andererseits über mit Koppelelementpaaren gebildete Koppelpunkte mit ebenfalls jeweils mit zwei Signalleitern gebildeten Matrixausgangsleitungen verbindbar sind, die jeweils mit ihren beiden Signalleitern zu den beiden Signaleingängen einer mit einem Differenzverstärker gebildeten Ausgangsverstärkerschaltung führen; diese Koppeleinrichtung ist erfindungsgemäß dadurch gekennzeichnet, daß in einer in FET-Technik ausgebildeten Koppelpunktmatrix die in den Koppelpunkten vorgesehenen Koppelelementpaare jeweils ein Paar von jeweils mit einem Schalter-Transistor und einem Vorschalt-Transistor gebildeten Serienschaltungen aufweisen, wobei die jeweils an ihrer Steuerelektrode gleichsinnig mit einem Durchschalte- bzw. Sperrsignal beaufschlagten Schalter-Transistoren jeweils mit einer Hauptelektrode an den einen bzw. anderen Signalleiter der zugehörigen Matrixausgangsleitung angeschlossen sind, die ihrerseits mit einem Ausgangs-Differenzverstärker mit Kippverhalten versehen ist, und wobei die jeweils mit ihrer Steuerelektrode an den einen bzw. anderen Signalleiter der zugehörigen Matrixeingangsschaltung angeschlossenen Vorschalt- Transistoren jeweils an einer Hauptelektrode über einen Abtast Transistor mit dem einen Anschluß der Betriebsspannungsquelle verbunden sind, mit deren anderen Anschluß jeder Signalleiter der jeweiligen Matrixausgangsleitung jeweils über einen Vorlade-Transistor verbunden ist, und daß Vorlade-Transistoren und Abtast-Transistor gegensinnig zueinander jeweils an ihrer Steuerelektrode mit einem eine Bit-Durchschaltezeitspanne in eine Vorladephase und die eigentliche Durchschaltephase unterteilenden Koppelfeld-Ansteuer-Takt beaufschlagt sind, so daß in jeder Vorphase bei gesperrtem Abtast-Transistor beide Signalleiter der Matrixausgangsleitung über den jeweiligen Vorlade-Transistor zumindest angenähert auf das an dem genannten anderen Anschluß der Betriebsspannungsquelle herrschende Potential geladen werden.

Die Erfindung bringt zusätzlich zu den Vorteilen, die mit einer in FET-Technik gehaltenen Koppelpunktmatrix verbunden sind, den weiteren Vorteil mit sich, daß einerseits - bei gesperrtem Koppelpunkt - auch ohne zusätzliche Dämpfungsmaßnahmen keine störende Signale über den Koppelpunkt zum Matrixausgang gelangen und daß andererseits - bei leitendem Koppelpunkt - bei einer bei der Bitdurchschaltung ggf. stattfindenden Umladung der Matrixausgangsleitung stets von dem dem einen Signalzustand entsprechenden einen Betriebspotential ausgehend in nur einer Umladerichtung vor sich gehen und somit bereits mit einer (dem Überschreiten einer diesem Betriebspotentialwert benachbarten Schwelle bzw. einer dem Kippunkt des Differenzverstärkers benachbarten Schwelle entsprechenden) kleinen Umladung - und damit entsprechend schnell - ein eindeutiger Übergang des am Ausgang der Koppeleinrichtung auftretenden, durchgeschalteten Digitalsignals von dem einen in den anderen Signalzustand verbunden ist.

Bei einer Realisierung der Koppelpunktmatrix in C-MOS-Technik erhöht sich im Vergleich mit Koppelpunktmatrizen, deren Koppelelemente mit C-MOS-Transfergates u./o. C-MOS-Invertern gebildet sind, die Arbeitsgeschwindigkeit weiter, wenn in weiterer Ausgestaltung der Erfindung die Schalter-,Vorschalt-und Abtast-Transistoren n-Kanal-Transistoren sind und allenfalls die Vorlade-Transistoren p-Kanal-Transistoren sind; wegen ihres höheren spezifischen Widerstands eine größere Fläche erfordernde p-Kanal-Transistoren sind so allenfalls nur matrixausgangsleitungsindividuell, jedenfalls aber nicht koppelpunktindividuell vorzusehen, so daß, was bei einer Integration von besonderer Bedeutung ist, die Koppelpunktmatrix mit entsprechend geringem Platzbedarf und mit entsprechend geringen Schaltungskapazitäten zu realisieren ist. Da die Verlustleistung der Koppelpunktmatrix überwiegend auf den Matrixleitungen zu erbringende Ladeleistung ist, verringert sich bei reduzierter kapazitiver Belastung der Matrixausgangsleitungen neben den Umladezeiten auch der Gesamtleistungsbedarf.

Weitere Besonderheiten der Erfindung werden aus der nachfolgenden näheren Erläuterung der Erfindung anhand der Zeichnung ersichtlich. Dabie zeigen

FIG 1

das Schema einer Breitband-Koppeleinrichtung gemäß der Erfindung;

FIG 2, FIG 3 und FIG 4

zeigen Beispiele der schaltungstechnischen Realisierung ihrer Koppelelemente, und

FIG 5

zeigt ein Beispiel der schaltungstechnischen Realisierung eines Differenzverstärkers mit Kippverhalten.

FIG 6

schliesslich verdeutlicht Signalverläufe darin.

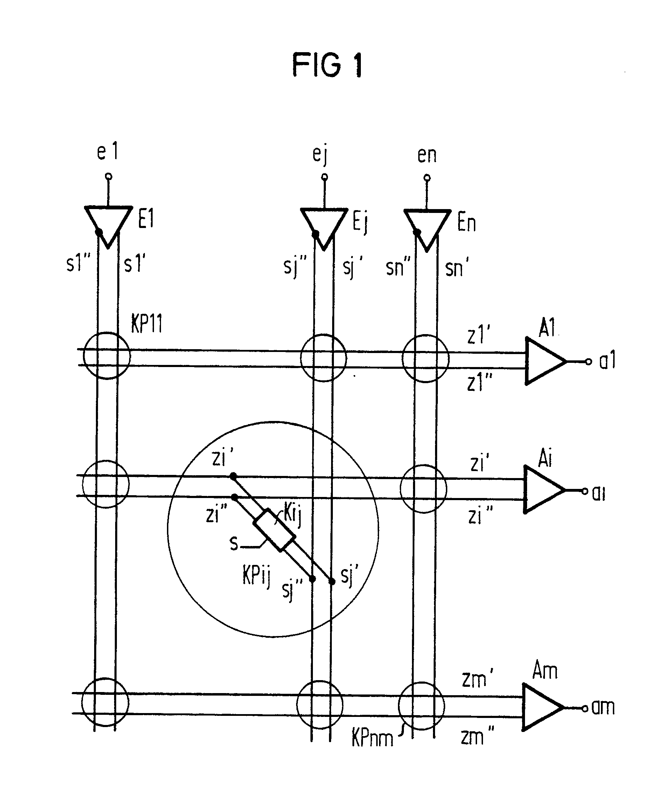

In der Zeichnung FIG 1 ist schematisch in zum Verständnis der Erfindung erforderlichem Umfange eine Breitbandsignal-Koppeleinrichtung skizziert, an deren zu Spaltenleitungen sl...sj...sn einer Koppelpunktmatrix führenden Eingängen el...ej...en Eingangsdigitalsignalschaltungen El...Ej...En vorgesehen sind und deren von Zeilenleitungen zl...zi...zm der Koppelpunktmatrix erreichte Ausgänge al...ai...am mit Ausgangsverstärkerschaltungen Al...Ai...Am versehen sind. Die Koppelpunktmatrix weist Koppelpunkte KPll...KPij...KPmn auf, deren Koppelelemente, wie dies beim Koppelpunkt KPij für ein Kopelelementepaar Kij weiter ins Einzelne gehend angedeutet ist, jeweils an einem Steuereingang s von einem (in der Zeichnung nicht mehr dargestellten) Adressendecoderelement oder Halte-Speicherelement gesteuert sein können, was hier indessen nicht weiter erläutert werden muss, da, wie eingangs schon erwähnt wurde, derartige Ansteuerungen von Koppelelementen allgemein bekannt sind und entsprechende Erläuterungen sich im übrigen auch schon an anderer Stelle finden (EP-A-87 113 203).

Die Matrixeingangsleitungen (Spaltenleitungen) sind jeweils mit zwei Signalleitern sl',sl";...;sj',sj";...;sn',sn" gebildet, die jeweils an Komplementär-(Differenz-) ausgänge der jeweils zugehörigen, in FIG 1 als Verstärker mit einem nichtinvertierenden und einem invertierenden Ausgang, d.h. als sog. Differenz-Leitungstreiber dargestellten Eingangsdigitalsignalschaltung El,...,Ej,...,En angeschlossen sind. Die so einerseits von den Komplementärausgängen der Eingangsdigitalsignalschaltungen E1,...,Ej,...,En ausgehenden Matrixeingangsleitungen (Spaltenleitungen) sl',sl";...;sj',sj";... ...;sn',sn" sind andererseits über mit Koppelelementepaaren (Kij beim Koppelpunkt KPij in FIG 1) gebildete Koppelpunkte KPll,...,KPij,..., KPnm mit Matrixausgangsleitungen (Zeilenleitungen) verbunden, die ebenfalls jeweils mit zwei Signalleitern zl',zl";...;zi',zi";...;zm',zm" gebildet sind und mit diesen jeweils zu den beiden Signaleingängen einer mit einem Differenzverstärker mit Kippverhalten gebildeten Ausgangsverstärkerschaltung Al,..,.Ai,...,Am führen.

Ein solcher Differenzverstärker mit Kippverhalten kann mit einem sog. gated flip-flop realisiert werden, wie es im Prinzip (aus |a| IEEE Journal of Solid-State Circuits, Oct. 1973, 319...323, Fig.6) und auch schon in verschiedenen Modifikationen (beispielsweise aus |b| DE-OS 24 22 136, Fig.3 (16') und aus |c| DE-OS 26 08 119, FIG.5) bekannt ist, wobei ein dort vorgesehener Symmetriertransistor (in|a|und |b|)ebenso wie dort vorgesehene Vorladetransistoren (in|b|) bzw. Lasttransistoren (in |c|) zweckmäßigerweise als p-Kanal-Transistor auszubilden ist.

Im Ausführungsbeispiel gemäß FIG 5 weist der ein Kippverhalten zeigende Differenzverstärker einer solchen Ausgangsverstärkerschaltung Al,...,Ai,...,Am zunächst ein -als solches nicht ständig wirksamgeschaltetes - bistabiles Kippglied B mit zwei kreuzgekoppelten CMOS-Inverterschaltungen Tpb',Tnb';Tpb",Tnb" auf, an deren zwei Ausgänge ai' und ai" die eine Speisepotentialquelle $U_{DD}$ auch gleichzeitig über zwei gleichsinnig taktsignalgesteuerte Schalttransistoren Tp' und Tp" es einen Kanaltyps - im Ausführungsbeispiel: p-Kanal-(Verarmungs-)Transistor - anschaltbar ist. Zwischen die zwei Transistoren Tnb' und Tnb" des anderen Kanaltyps - im Ausführungsbeispiel: n-Kanal-(Anreicherungs-)Transistor - und die andere Speisepotentialquelle $U_{SS}$ ist eine Ansteuerschaltung C mit zwei weiteren, zwischen diese Transistoren Tnb', Tnb" und die Speisepotentialquelle $U_{SS}$ eingefügten Transistoren Tn', Tn" gleichen Typs und zweier diesen zwei weiteren Transistoren Tn',Tn" parallelgeschalteten Serienschaltungen jeweils aus einem mit dem Eingangssignal bzw. mit dem negierten Eingangssignal gesteuerten MOS-Transistor Tnz' bzw. Tnz" gleichen Typs und einem taktsignalgesteuerten MOS-Transistor Tnt' bzw. Tnt" gleichen Typs eingefügt; zwischen den zwei Verbindungspunkten v',v" der zwei kreuzgekoppelten C-MOS-Inverterschaltungen Tpb', Tnb' und Tpb", Tnb" und der (symmetrisch dimensionierten) Ansteuerschaltung C ist ein Transistor Tn gleichen Typs eingefügt, über den die zwei kreuzgekoppelten C-MOS-Inverterschaltungen zum bistabilen Kippglied zusammenschaltbar sind. An seinen Betriebsspannungsklemmen $U_{DD}$ möge dem in FIG 5 skizzierten Differenzverstärker mit Kippverhalten ein Speisepotential von beispielsweise +5 Volt gegenüber dem an den Betriebsspannungsklemmen $U_{SS}$ (Masse) gegebenen Potential zugeführt werden.

Bevor unten noch näher erläutert wird, wie der in FIG 5 skizzierte Differenzverstärker mit Kippverhalten arbeitet, sei jetzt ein Blick auf die Koppelementpaare ...Kij... geworfen:

Wie die Koppelelementepaare ...Kij... schaltungstechnisch realisiert sein können, wird in FIG 2, FIG 3 und FIG 4 verdeutlicht: Die jeweils mit zwei jeweils an der Steuerelektrode mit einem Durchschalte- bzw. Sperrsignal beaufschlagten und mit einer Hauptelektrode an den einen bzw. den anderen Signalleiter zi',zi" der zugehörigen Matrixausgangsleitung angeschlossenen Schalter-Transistoren Tnk', Tnk" gebildeten Koppelelementepaare ...Kij... weisen jeweils zwei jeweils mit einem Schalter-Transistor Tnk' bzw. Tnk" eine Serienschaltung bildende Vorschalt-Transistoren Tne' und Tne" auf, die jeweils mit der Steuerelektrode an den einen Signalleiter sj' bzw. den anderen Signalleiter sj" der zugehörigen Matrixeingangsleitung (Spaltenleitung) ... sj... angeschlossen sind und deren jeweilige der Serienschaltung abgewandte Hauptelektrode über einen Abtast-Transistor Tna (nämlich Tnaij in FIG 2 bzw. Tnaj in FIG 3 bzw. Tnai in FIG 4) mit dem einen Anschluß $U_{SS}$ (Masse) der Betriebsspannungsquelle verbunden ist; mit dem anderen Anschluß $U_{DD}$ der Betriebsspannungsquelle sind die beiden Signalleiter (zi',zi") der jeweiligen Matrixausgangsleitung (Zeilenleitung) ...zi... jeweils über einen Vorlade-Transistor Tpi' bzw. Tpi" verbunden.

Dabei kann, wie dies auch FIG 2 verdeutlicht, jeweils ein koppelelementepaar-individueller Abtast-Transistor Tnaij vorgesehen sein; alternativ kann aber auch, wie dies FIG 3 zeigt, jeweils für alle an ein und derselben Matrixeingangsleitung (Spaltenleitung) ..sj.. liegenden Koppelelementpaare ein gemeinsamer und damit matrixeingangsleitungs-individueller Abtast-Transistor (Tnaj in FIG 3) vorgesehen sein, oder es kann, wie die aus FIG 4 ersichtlich ist, jeweils ein allen an ein und derselben Matrixausgangsleitung (Zeilenleitung) ...zi... liegenden Koppelelementepaaren gemeinsamer und damit matrixausgangsleitungs-individueller Abtast-Transistor (Tnai in FIG 4) vorgesehen sein.

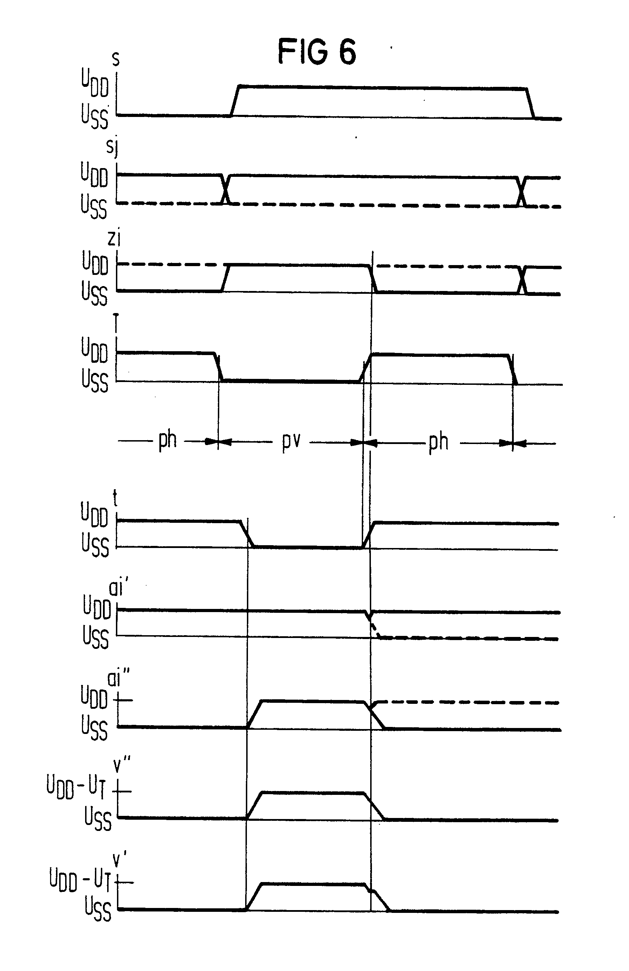

Wie dies auch in FIG 2 bis FIG 4 angedeutet ist, können - bei in CMOS-Technik gehaltener Koppelpunktmatrix - die Schalter-Transistoren Tnk, die Vorschalt-Transistoren Tne und Abtast-Transistoren Tna n-Kanal-Transistoren sein und die Vorlade-Transistoren Tpi p-Kanal-Transistoren. Vorlade-Transistoren Tpi und Abtast-Transistoren Tna sind gegensinnig zueinander jeweils an ihrer Steuerelektrode mit einem eine Bit-Durchschaltezeitspanne in in FIG 6, Mitte, angedeuteter Weise in eine Vorphase pv und eine Hauptphase ph unterteilenden Takt T beaufschlagt, wie er in FIG 6 in Zeile T angedeutet ist.

Während der Vorphase pv (siehe FIG 6, Mitte) werden jeweils die beiden Signalleiter (zi',zi") der Matrixausgangsleitungen (Zeilenleitungen) ...zu... über den jeweiligen Vorlade-Transistor (Tpi' bzw. Tpi" in FIG 2 bis FIG 4) zumindest angenähert auf das $U_{DD}$-Betriebspotential geladen, wozu die im Beispiel durch p-Kanal-Transistoren gebildeten Vorlade-Transistoren Tpi', Tpi" im Beispiel durch ein "Low"-Taktsignal T (siehe FIG 5, Zeile T) leitend gemacht werden. Zugleich werden die durch n-Kanal-Transistoren gebildeten Abtast-Transistoren Tna (Tnaj in FIG 2, Tnaj in FIG 3, Tnai in FIG 4) im Beispiel durch das gleiche "Low"-Taktsignal T im entgegengesetzten Sinne ausgesteuert, d.h. gesperrt, so daß die Aufladung der jeweils beiden Signalleiter (zi', zi") der Matrixausgangsleitungen (Zeilenleitungen) ...zi... unabhängig von der Ansteuerung der jeweiligen Schalter-Transistoren Tnk', Tnk" (in FIG 2 bis FIG 4) und der jeweiligen Vorschalt-Transistoren Tne', Tne" (in FIG 2 bis FIG 4) der einzelnen Koppelelementepaare ...Kij... vor sich gehen kann. Auf der jeweiligen Matrixeingangsleitung (Spaltenleitung) ...sj... kann sich dabei ggf. schon das dem jeweils durchzuschaltenden Bit entsprechende Potential aufbauen (bzw. beibehalten werden), wie dies Zeile sj in FIG 6 verdeutlicht.

In der darauffolgenden Hauptphase ph (siehe FIG 6, Mitte), werden im Beispiel durch ein "High"-Taktsignal T (siehe FIG 6, Zeile T) die Vorlade-Transistoren Tpi', Tpi" (in FIG 2 bis FIG 4) gesperrt und zugleich die Abtast-Transistoren Tna (Tnaij in FIG 2, Tnaj in FIG 3, Tnai in FIG 4) entriegelt. Sind nun in einem Koppelelementepaar ...Kij... dessen im Beispiel durch n-Kanal-Transistoren gegebene Schalt-Transistoren Tnk', Tnk" (in FIG 2 bis FIG 4) aufgrund eines am Steuereingang s anliegenden (im Beispiel "High"-)Durchschaltesignals (siehe FIG 6, Zeile s) leitend und befindet sich damit der Koppelpunkt im Durchschaltezustand, so werden jetzt je nach den dem durchzuschaltenden Bit entsprechenden, auf den beiden Signalleitern sj', sj" der betreffenden Matrixeingangsleitung (Spaltenleitung) ...sj... herrschenden Signalzuständen die Signalleiter zi',zi" der mit dieser Matrixeingangsleitung (Spaltenleitung) ...sj... über das betreffende Koppelelement ..Kij.. verbundene Matrixausgangsleitung (Zeilenleitung) ...zi... entladen werden bzw. auf dem in der Vorphase pv angenommenen $U_{DD}$-Potential verbleiben:

Herrscht auf einem Signalleiter sj' bzw. sj" der betreffenden Matrixeingangsleitung (Spaltenleitung) sj der "Low"-Signalzustand, wie dies in FIG 6, Zeile sj, mit einer gestrichelten Linie angedeutet ist, und ist dementsprechend der (n-Kanal-)Vorschalt-Transistor Tne' bzw. Tne" (in FIG 2 bis FIG 4) des betreffenden Koppelelementepaares Kij gesperrt, so wird der betreffende Signalleiter zi' bzw. zi" der Matrixausgangsleitung (Zeilenleitung)

zi über das betreffende Koppelement dieses Koppelelementepaares Kij nicht entladen, sondern behält, sofern kein anderer zu dieser Matrixausgangsleitung (Zeilenleitung) zi führender Koppelpunkt sich im Durchschaltezustand befindet, den $U_{DD}$-Potentialzustandbei.

Herrscht dagegen auf dem gerade betrachteten Signalleiter sj',sj" der Matrixeingangsleitung (Spaltenleitung) sj der "High"-Signalzustand, wie dies in FIG 6, Zeile sj, mit einer durchgezogenen Linie angedeutet ist, und ist dementsprechend der Vorschalt-Transistor Tne' bzw. Tne" (in FIG 2 bis FIG 4) des betrachteten Koppelelementepaares Kij ebenso wie der Schalter-Transistor Tnk' bzw. Tnk" und der zugehörige Abtast-Transistor Tna leitend, so wird der zugeordnete Signalleiter zi' bzw. zi" der Matrixausgangsleitung (Zeilenleitung) zi über dieses Koppelelement des Koppelelementepaares Kij entladen und auf das $U_{SS}$-Potential gezogen.

Über einen von seinem Steuereingang s her entriegelten Koppelpunkt wird somit das jeweilige Eingangssignal jeweils invertiert durchgeschaltet.

In den im vorstehenden anhand von FIG 2 bis FIG 4 erläuterten Ausführungsbeispielen sind die Vorlade-Transistoren (Tpi',Tpi") durch p-Kanal-Transistoren gebildet, wobei diese p-Kanal-Vorlade-Transistoren (Tpi) und die durch n-Kanal-Transistoren gebildeten Abtast-Transistoren (Tna), durch den unterschiedlichen Kanaltypus bedingt, durch ein und dasselbe Signal (T) gegensinnig zueinander gesteuert werden. In Abweichung hiervon ist es aber auch möglich, die Vorlade-Transistoren mit n-Kanal-Transistoren zu realisieren, so daß, wenn auch die Schalter-Transistoren (Tnk), die Vorschalt-Transistoren (Tna) und die Abtast-Transistoren (Tna) n-Kanal-Transistoren sind, nur Transistoren ein und desselben Kanaltyps zur Anwendung kommen; damit dann Vorlade-Transistoren und Abtast-Transistoren wiederum gegensinnig zueinander jeweils an ihrer Steuerelektrode mit dem Koppelfeld-Ansteuer-Takt beaufschlagt werden, ist den Abtast-Transistoren (Tna) wiederum, wie in den anhand von FIG 2 bis FIG 4 beschriebenen Ausführungsbeispielen, das Koppelfeld-Ansteuer-Taktsignal (T) direkt zuzuführen, den (n-Kanal-)Vorlade-Transistoren dagegen das invertierte Koppelfeld-Ansteuer-Taktsignal.

Es soll nun auf die jeweils mit einem mit den beiden Signaleingängen zi',zi" (in FIG 1 und FIG 5) an die beiden Signalleiter zi', zi" (in FIG 1 bis FIG 4) einer Matrixausgangsleitung angeschlossenen, Kippverhalten zeigenden Differenzverstärker gebildeten Ausgangsverstärkerschaltungen ..Ai.. (in FIG 1) zurückgekommen und erläutert werden, wie der in FIG 5 skizzierte Differenzverstärker mit Kippverhalten arbeitet.

Es sei angenommen, daß in der in FIG 5 dargestellten Ausgangsverstärker schaltung Ai aufgrund eines zuvor durchgeschalteten Bits auf dem Signalleiter zi' (FIG 1 bis FIG 5) ein Low-Signal (nämlich mit einem deutlich unter dem $U_{DD}$-Pegel liegenden Signalpegel) und auf dem Signalleiter zi" ein $U_{DD}$-Signal (vgl. FIG 6, Zeile zi) auftritt und daß demzufolge bei einem an den Takteingängen t (in FIG 5) anstehenden Taktsignal gemäß FIG 6, Zeile t, vom Potentialwert $U_{DD}$ (+5 V) in den zu einem bistabilen Kippglied B geschalteten zwei kreuzgekoppelten C-MOS-Inverterschaltungen Tpb', Tnb' und Tpb", Tnb" der p-Kanal-Transistor Tpb' der einen Inverterschaltung und der n-Kanal-Transistor Tnb" der anderen Inverterschaltung leitend und der n-Kanal-Transistor Tnb' der einen Inverterschaltung und der p-Kanal-Transistor Tpb" der anderen Inverterschaltung nichtleitend sind, so daß am Inverterausgang ai' der einen C-MOS-Inverterschaltung das $U_{DD}$-Potential (+5 Volt) auftritt und am Inverterausgang ai" der anderen C-MOS-Inverterschaltung das - bei leitenden Transistoren Tn" und Tn', Tnt", Tnz" der Ansteuerschaltung C an deren Verbindungspunkt v" (ebenso wie am Verbindungspunkt v') mit dem bistabilen Kippglied B gegebene -$U_{SS}$-Potential (Masse).

Springt zu Beginn einer Signalübernahme-Vorbereitungsphase das an den Takteingängen t (in FIG 5) anstehende Taktsignal gemäß FIG 6, Zeile t, auf den Wert $U_{SS}$ (Masse), so werden bei dem bistabilen Kippglied B die zwei gleichsinnig taktsignalgesteuerten p-Kanal-Schalttransistoren Tp' und Tp" leitend, so daß beiden Inverterausgängen ai' und ai" das $U_{DD}$-Potential (+5 Volt) aufgeprägt wird mit der Folge, daß dann in beiden C-MOS-Inverterschaltungen jeweils der p-Kanal-Transistor Tpb' bzw. Tpb" nichtleitend und der n-Kanal-Transistor Tnb' bzw. Tnb" leitend ist. An beiden Verbindungspunkten v' und v" zwischen dem (bisherigen) bistabilen Kippglied B und der Ansteuerschaltung C ist dann bei einer Schwellenspannung $U_T$ der n-Kanal-Transistoren Tnb', Tnb" von beispielsweise 1 Volt ein Potential $U_{DD} - U_T$ von beispielsweise +4 Volt gegeben; dabei sind in der Ansteuerschaltung C zumindest die Transistoren Tn, Tn", Tn', Tnt" und Tnt' nichtleitend.

Die nachfolgende Signalübernahmephase beginnt mit dem Ansteigen des an den Takteingängen t (in FIG 5) auftretenden Taktsignals gemäß FIG 6, Zeile t, vom Potentialwert $U_{SS}$ auf den Potentialwert $U_{DD}$; im Verlauf des Taktsignalanstiegs wird das am Eingang zi' des Differenzverstärkers nach FIG 5 anstehende Eingangssignal, wie es in FIG 6 in Zeile zi skizziert ist, abgetastet:

Mit zunehmendem Taktsignalpotential werden zunächst in der Ansteuerschaltung C die beiden Haltetransistoren Tn' und Tn" sowie die Abtasttransistoren Tnt' und Tnt" leitend; dabei kommt es an den Verbindungspunkten v' und v" zu einem Stromfluß, aufgrund dessen die Potentiale an den Verbin-

dungspunkten v' und v" abgesenkt werden. Der Verstärkertransistor Tn bleibt dabei zunächst, nämlich solange die Verbindungspunkte v' und v" auf zu hohem Potential liegen und das Taktsignalpotential noch zu niedrig ist, gesperrt, so daß die kreuzgekoppelten C-MOS-Inverter Tpb', Tnb' und Tpb", Tnb" noch nicht zu einem bistabilen Kippglied wirdsamgeschaltet sind. Die über die Verbindungspunkte v' und v" zwischen dem - als solches noch nicht wirksamgeschalteten -bistabilen Kippglied B und der Ansteuerschaltung C fließenden Ströme bewirken über die n-Kanal-Transistoren Tnb' und Tnb" der beiden C-MOS-Inverterschaltungen auch entsprechende Potentialabsenkungen an den Inverterausgängen ai' und ai".

Ist nun, wie dies in FIG 6 in Zeile zi mit einer gestrichelten Linie verdeutlicht ist, zu dieser Zeit am Verstärkereingang zi' (in FIG 5) der $U_{DD}$-Signalpegel gegeben, aufgrund dessen der Eingangssignaltransistor Tnz' der Ansteuerschaltung C stark leitend ist, während am Verstärkereingang zi" ein Signal mit deutlich unter dem $U_{DD}$-Signalpegel liegendem Pegel auftritt, das den Eingangssignaltransistor Tnz" in seiner Leitfähigkeit entsprechend herabsetzt, so weist die Parallelschaltung aus der Transistor-Serienschaltung Tnt', Tnz' und dem weiteren n-Kanal-Transistor Tn' einen niedrigeren Widerstand auf als die Parallelschaltung aus dem weiteren n-Kanal-Transistor Tn" und der Transistor-Serienschaltung Tnt", Tnz", so daß, nachdem die beiden Lasttransistoren Tpb' und Tpb" gleich stark ausgesteuert und daher in gleichem Ausmaße leitend sind, der über den Verbindungspunkt v' fließende Strom größer ist als der über den Verbindungspunkt v" fließende Strom. Die Potentialabsenkung am Inverterausgang ai' ist daher kräftiger als diejenige am Inverterausgang ai" mit der Folge einer entsprechend kräftigeren Nichtleitendwerdens des mit seiner Gate-Elektrode am Inverterausgang ai' liegenden Treibertransistors Tnb", was den über den Verbindungspunkt v" fließenden Strom weiter kleiner als den über den Verbindungspunkt v' fließenden Strom hält. Es sei bemerkt, daß, obwohl über den Verbindungspunkt v" der kleinere Strom fließt, wegen der Ansteuerung der beiden Treibertransistoren Tnb" und Tnb' vom jeweils anderen Inverterausgang ai' bzw. ai" her das Potential am Verbindungspunkt v" genauso kräftig absinkt wie das Potential am Inverterausgang ai', während umgekehrt das Potential am Verbindungspunkt v' dem Potential am Inverterausgang ai" folgt.

Übersteigt das Potential an den Taktsignaleingängen t das Potential des Verbindungspunktes v" um mehr als die Schwellenspannung des Verstärkertransistors Tn, so wird dieser Transistor leitend, wobei seine Drain-Elektrode beim Verbindungspunkt v' und seine Source-Elektrode beim Verbindungspunkt v" liegt. Dies hat zur Folge, daß der über den Verbindungspunkt v" fließende, ohnehin schon kleinere Strom nunmehr zum größten Teil vom Treibertransistor Tnb' her gezogen und somit dem bisher schon über den Verbindungspunkt v' fließenden, größeren Strom noch überlagert wird, wodurch das Potential an dem einen Inverterausgang ai' weiter absinkt, während das Potential am anderen Inverterausgang ai" wieder ansteigt. Die beiden Verbindungspunkte v' und v" gelangen durch den leitenden Verstärkertransistor Tn auf gleiches Potential, das durch die Haltetransistoren Tn', Tnb" weiter zum (Masse-)Potential $U_{SS}$ gezogen wird. Die kreuzgekoppelten C-MOS-Inverterschaltungen Tpb', Tnb' und Tpb", Tnb" sind nunmehr zum bistabilen Kippglied wirksam zusammengeschaltet; dieses bistabile Kippglied kippt vom labilen Zustand in einen stabilen Zustand, wobei das Potential an dem einen Inverterausgang ai' gemäß FIG 6, Zeile ai', auf den Wert $U_{SS}$ (Masse) gelangt und das Potential am anderen Inverterausgang ai" gemäß FIG 6, Zeile ai", auf den Wert $U_{DD}$ ( + 5 Volt).

Ist dagegen, wie dies in FIG 6 in Zeile zi durchgezogen dargestellt ist, zu der Signalübernahmezeit am Verstärkereingang zi' (FIG 5) ein deutlich unterhalb des $U_{DD}$-Pegels liegender Signalpegel gegeben, so daß der Eingangssignaltransistor Tnz' der Ansteuerschaltung C allenfalls schwach leitend ist, während bei am Verstärkereingang zi" auftretendem $U_{DD}$-Signal der Eingangssignaltransistor Tnz" stark leitet, und weist daher die Parallelschaltung aus dem Haltetransistor Tn' und der Serienschaltung von Eingangssignaltransistor Tnz' und Abtasttransistor Tnt' einen höheren Widerstand auf als die Parallelschaltung aus dem Haltetransistor Tn" und der Serienschaltung von Eingangssignaltransistor Tnz" und Abtasttransistor Tnt", so kommt es in einer de n vorstehend erläuterten Vorgängen spiegelbildlich entsprechenden Weise zu einem Übergang des wirksamwerdenden bistabilen Kippgliedes B von seinem labilen Zustand in den anderen stabilen Zustand, in dem, wie dies in FIG 6 durchgezogen dargestellt ist, am Inverterausgang ai' gemäß Zeile ai' in FIG 6 das $U_{DD}$-Potential und am Inverterausgang ai" gemäß FIG 2, Zeile ai", das $U_{SS}$-Potential auftritt.

Der das im Vorstehenden zum Ausdruck kommende Kippverhalten zeigende Differenzverstärker Ai wurde im Vorstehenden anhand eines Ausführungsbeispiels erläutert, das zwischen den n-Kanal-Transistoren der beiden zu einem bistabilen Kippglied B zusammenschaltbaren C-MOS-Inverterschaltungen und der zugehörigen Speisepotentialquelle $U_{SS}$ eine Ansteuerschaltung C vorsieht. Es sei indessen bemerkt, daß abweichend davon auch eine dann mit p-Kanal-Transistoren aufgebaute Ansteuerschaltung zwischen den p-Kanal-Transistoren der beiden C-MOS-Inverterschaltungen und der zugehörigen Speisepotentialquelle U $_{DD}$ (in FIG 5) vorgesehen sein kann, wobei die Übernahme eines Eingangssignals dann mit der fallenden Takt-Signalflanke vor sich geht, ohne daß dies hier indessen noch weiter ins Einzelne gehend erläutert werden müßte.

## Patentansprüche

1. Breitbandsignal-Koppeleinrichtung mit einer Koppelpunktmatrix, die jeweils mit zwei Signalleitern (sj', sj") gebildete Matrixeingangsleitungen (sj) aufweist, die einerseits jeweils mit ihren beiden Signalleitern (sj', sj") an zwei Differenz-(Komplementär-)ausgängeeiner Eingangsdigitalsignalschaltung (Ej) angeschlossen sind und andererseits über mit Koppelelementpaaren (Kij) gebildete Koppelpunkte (KPij) mit ebenfalls jeweils mit zwei Signalleitern (zi', zi") gebildeten Matrixausgangsleitungen (zi) verbindbar sind, die jeweils mit ihren beiden Signalleitern (zi', zi") zu den beiden Signaleingängen einer mit einem Differenzverstärker gebildeten Ausgangsverstärkerschaltung (Ai) führen,
**dadurch gekennzeichnet,**
daß in einer in FET-Technik ausgebildeten Koppelpunktmatrix die in den Koppelpunkten (KPij) vorgesehenen Koppelelementpaare (Kij) jeweils ein Paar von jeweils mit einem Schalter-Transistor (Tnk', Tnk") und einem Vorschalt-Transistor (Tne', Tne") gebildeten Serienschaltungen aufweisen,
wobei die jeweils an ihrer Steuerelektrode gleichsinnig mit einem Durchschalte- bzw. Sperrsignal beaufschlagten Schalter-Transistoren (Tnk', Tnk") jeweils mit einer Hauptelektrode an den einen bzw. anderen Signalleiter (zi', zi") der zugehörigen Matrixausgangsleitung (zi) angeschlossen sind, die ihrerseits mit einem Ausgangs-Differenzverstärker (Ai) mit Kippverhalten versehen ist, und wobei die jeweils mit ihrer Steuerelektrode an den einen bzw. anderen Signalleiter (sj', sj") der zugehörigen Matrixeingangsschaltung (sj) angeschlossenen Vorschalt-Transistoren (Tne', Tne") jeweils an einer Hauptelektrode über einen Abtast-Transistor (Tna) mit dem einen Anschluß (U$_{SS}$,Masse) der Betriebsspannungsquelle verbunden sind, mit deren anderen Anschluß (U$_{DD}$) jeder Signalleiter (zi', zi") der jeweiligen Matrixausgangsleitung (zi) jeweils über einen Vorlade-Transistor (Tpi', Tpi") verbunden ist, und daß Vorlade-Transistoren (Tpi', Tpi") und Abtast-Transistor (Tna) gegensinnig zueinander jeweils an ihrer Steuerelektrode mit einem eine Bit-Durchschaltezeitspanne in eine Vorladephase (pv) und die eigentliche Durchschaltephase (ph) unterteilenden Koppelfeld-Ansteuer-Takt (T) beaufschlagt sind, so daß in jeder Vorphase (pv) bei gesperrtem Abtast Transistor (Tna) beide Signalleiter der Matrixausgangsleitung (zi) über den jeweiligen Vorlade-Transistor (Tpi', Tpi") zumindest angenähert auf das an dem genannten anderen Anschluß (U$_{DD}$) der Betriebsspannungsquelle herrschende Potential geladen werden.

2. Breitbandsignal-Koppeleinrichtung nach Anspruch 1,
**dadurch gekennzeichnet,**
daß die Schalter-Transistoren (Tnk), die Vorschalt-Transistoren (Tne) und die Abtast-Transistoren (Tna) n-Kanal-Transistoren und die Vorlade-Transistoren (Tpi) p-Kanal-Transistoren sind.

3. Breitbandsignal-Koppeleinrichtung nach Anspruch 1,
**dadurch gekennzeichnet,**
daß sowohl die Schalter-Transistoren (Tnk), die Vorschalt-Transistoren (Tne) und die Abtast-Transistoren (Tna) als auch die Vorlade-Transistoren (Tpi) n-Kanal-Transistoren sind.

4. Breitbandsignal-Koppeleinrichtung nach einem der Ansprüche 1 bis 3,
**dadurch gekennzeichnet,**
daß jeweils ein koppelelement-individueller Abtast-Transistor (Tnaij) vorgesehen ist.

5. Breitbandsignal-Koppeleinrichtung nach einem der Ansprüche 1 bis 3,
**dadurch gekennzeichnet,**
daß jeweils ein matrixeingangsleitungs-individueller Abtast-Transistor (Tnaj) vorgesehen ist.

6. Breitbandsignal-Koppeleinrichtung nach einem der Ansprüche 1 bis 3,
**dadurch gekennzeichnet,**
daß jeweils ein matrixausgangsleitungs-individueller Abtast-Transistor (Tnai) vorgesehen ist.

7. Breitbandsignal-Koppeleinrichtung nach einem der Ansprüche 1 bis 6,
**dadurch gekennzeichnet,**
daß der Differenzverstärker mit Kippverhalten
   - zwei kreuzgekoppelte C-MOS-Inverterschaltungen (Tpb', Tnb'; Tpb", Tnb"),
      - an deren zwei Ausgänge (ai', ai") die eine Speisepotentialquelle (U $_{DD}$) auch gleichzeitig über zwei gleichsinnig taktsignalgesteuerte Schalttransistoren (Tp'; Tp") des einen Kanaltyps anschaltbar ist,

- und eine zwischen deren zwei Transistoren (Tnb'; Tnb") des anderen Kanaltyps und die andere Speisepotentialquelle ($U_{SS}$) eingefügte Ansteuerschaltung (C) mit
  - zwei weiteren, zwischen diese Transistoren (Tnb'; Tnb") und die Speisepotentialquelle ($U_{SS}$) eingefügten Transistoren (Tn'; Tn") gleichen Typs,
  - zwei diesen zwei weiteren Transistoren (Tn';Tn") parallelgeschalteten Serienschaltungen jeweils aus einem mit dem Eingangssignal bzw. dem negierten Eingangssignal gesteuerten MOS-Transistor (Tnz';Tnz") gleichen Typs und einem taktsignalgesteuerten MOS-Transistor (Tnt';Tnt") gleichen Typs
  - und einem zwischen den zwei Verbindungspunkten (v'; v") der zwei kreuzgekoppelten C-MOS-Inverterschaltungen (Tpb', Tnb'; Tpb", Tnb") und der Ansteuerschaltung (C) eingefügten Transistor (Tn) gleichen Typs, über den die zwei kreuzgekoppelten C-MOS-Inverterschaltungen zu einem bistabilen Kippglied zusammenschaltbar sind,

aufweist.

## Claims

1. Switching device for broadband signals, comprising a switching point matrix which in each case exhibits matrix input lines (sj) formed by means of two signal conductors (sj', sj"), which, on the one hand, are in each case connected with their two signal conductors (sj', sj") to two differential (complementary) outputs of a digital signal input circuit (Ej), and, on the other hand, can be connected via switching points (KPij), formed by means of switching element pairs (Kij), to matrix output lines (zi), also in each case formed by means of two signal conductors (zi', zi"), which in each case lead with both their signal conductors (zi', zi") to the two signal inputs of an output amplifier circuit (Ai) formed by means of a differential amplifier, characterised in that in a switching point matrix designed using FET technology, the switching element pairs (Kij) provided at the switching points (KPij) in each case exhibit a pair of series circuits in each case formed by means of a switch transistor (Tnk', Tnk") and a series transistor (Tne', Tne"), in which arrangement the switch transistors (Tnk', Tnk"), to the control electrode of which in each case a switching-through or inhibit signal is applied in the same direction, are in each case connected with a main electrode to one or the other signal conductor (zi', zi"), respectively, of the associated matrix output line (zi) which, in turn, are provided with a differential output amplifier (Ai) with triggering characteristic, and in which arrangement the series transistors (Tne', Tne"), which are in each case connected with their control electrode to one or the other signal conductor (sj', sj"), respectively, of the associated matrix input circuit (sj), are in each case connected with a main electrode via a sampling transistor (Tna) to one terminal ($U_{SS}$, earth) of the operating voltage source, to the other terminal ($U_{DD}$) of which each signal conductor (zi', zi") of the respective matrix output line (zi) is in each case connected via a precharging transistor (Tpi', Tpi"), and in that precharging transistors (Tpi', Tpi") and sampling transistor (Tna) have in each case applied to their control electrode in opposite directions with respect to one another a switching matrix activating clock (T) which subdivides a bit switching-through period into a precharging phase (pv) and the actual switching-through phase (ph) so that, in each preliminary phase (pv), when the sampling transistor (Tna) is inhibited, both signal conductors of the matrix output line (zi) are at least approximately charged to the potential prevailing at the said other terminal ($U_{DD}$) of the operating voltage source via the respective precharging transistor (Tpi', Tpi").

2. Switching device for broadband signals according to Claim 1, characterised in that the switching transistors (Tnk), the series transistors (Tne) and the sampling transistors (Tna) are n-channel transistors and the precharging transistors (Tpi) are p-channel transistors.

3. Switching device for broadband signals according to Claim 1, characterised in that the switch transistors (Tnk), the series transistors (Tne) and the sampling transistors (Tna) as well as the precharging transistors (Tpi) are n-channel transistors.

4. Switching device for broadband signals according to one of Claims 1 to 3, characterised in that in each case a switching-element-individual sampling transistor (Tnaij) is provided.

5. Switching device for broadband signals according to one of Claims 1 to 3, characterised in that in each case a matrix-input-line-individual sampling transistor (Tnaj) is provided.

6. Switching device for broadband signals according to one of Claims 1 to 3, characterised in that in each case a matrix-output-line-individual sampling transistor (Tnai) is provided.

7. Switching device for broadband signals according to one of Claims 1 to 6, characterised in that the differential amplifier with triggering characteristic has

- two cross-coupled CMOS inverter circuits (Tpb', Tnb';Tpb", Tnb"),
- to the two outputs (ai', ai") of which one feed potential source ($U_{DD}$) can also be connected simultaneously via two switching transistors (Tp'; Tp") of one channel type, which can be clock-signal-controlled in the same direction,
- and an activating circuit (C), which is inserted between its two transistors (Tnb'; Tnb") of the other channel type and the other feed potential source ($U_{SS}$), comprising
- two further transistors (Tn'; Tn") of the same type, which are inserted between these transistors (Tnb'; Tnb") and the feed potential source ($U_{SS}$),
- two series circuits, connected to and parallel with these two further transistors (Tn'; Tn"), in each case of a MOS transistor (Tnz'; Tnz") of the same type, controlled with the input or the negated input signal, and a clock-signal-controlled MOS transistor (Tnt'; Tnt") of the same type,
- and a transistor (Tn) of the same type, which is inserted between the two junctions (v'; v") of the two cross-coupled CMOS inverter circuits (Tpb', Tnb'; Tpb", Tnb") and the activating circuit (C), via which the two cross-coupled CMOS inverter circuits can be connected together to form a bistable flip flop.

## Revendications

1. Dispositif de couplage pour signaux à large bande comportant une matrice de points de couplage, qui comprend des lignes d'entrée (sj) de la matrice, qui sont constituées respectivement de deux conducteurs (sj', sj") de transmission de signaux, et, d'une part, sont raccordées, respectivement par leurs deux conducteurs (sj', sj") de transmission de signaux, à deux sorties différentielles (complémentaires) d'un circuit (Ej) de transmission de signaux numériques d'entrée, et, d'autre part, peuvent être raccordées, par l'intermédiaire de points de couplage (KPij), formés par des couples d'éléments de couplage (Kij), à des lignes de sortie (zi) de la matrice, qui sont également formées respectivement de deux conducteurs de transmission de signaux (zi', zi") et sont raccordées, respectivement par leurs deux conducteurs de transmission de signaux (zi', zi") aux deux entrées de signaux d'un circuit amplificateur de sortie (Ai) formé par un amplificateur différentiel, caractérisé par le fait que dans une matrice de points de couplage formée selon la technique FET, les couples (Kij) d'éléments de couplage, prévus au niveau des points de couplage (KPij) comportent respectivement un couple de circuits série formés respectivement par un transistor formant interrupteur (Tnk', Tnk") et par un transistor amont (Tne', Tne"), les transistors formant interrupteurs (Tnk', Tnk"), qui sont chargés dans le même sens, respectivement au niveau de leurs électrodes de commande, par un signal de mise à l'état passant ou de blocage, sont raccordés respectivement par une électrode principale à l'un ou à l'autre des conducteurs de transmission de signaux (zi', zi") de la ligne de sortie associée (zi) de la matrice, qui comporte, pour sa part, un amplificateur différentiel de sortie (Ai) ayant un comportement de bascule, alors que les transistors amont (Tne', Tne"), qui sont raccordés respectivement par leurs électrodes de commande à l'un et à l'autre des conducteurs de transmission de signaux (sj', sj") du circuit d'entrée associé (Sj) de la matrice, sont raccordés, respectivement au niveau d'une électrode principale, par l'intermédiaire d'un transistor d'échantillonnage (Tna), à une borne ($U_{SS}$, masse) de la source de tension de service, à l'autre borne ($U_{DD}$) de laquelle chaque conducteur de transmission de signaux (zi', zi") de la ligne de sortie respective (zi) de la matrice est raccordé respectivement par l'intermédiaire d'un transistor de précharge (Tpi', Tpi"), et que des transistors de précharge (Tpi', Tpi") et un transistor d'échantillonnage (Tna) sont chargés réciproquement en des sens opposés, respectivement au niveau de leur électrode de commande, par une cadence de commande (T) du champ de couplage, qui subdivise un intervalle de temps de transmission des bits en une phase de précharge (pv) et en la phase proprement dite de transmission (ph), de sorte que pendant chaque phase de précharge (pv), alors que le transistor d'échantillonnage (Tna) est bloqué, les deux conducteurs de transmission de signaux de la ligne de sortie (zi) de la matrice sont chargés, par l'intermédiaire du transistor respectif de précharge (Tpi', Tpi"), au moins approximativement au potentiel présent sur ladite autre borne ($U_{DD}$) de la source de tension de service.

2. Dispositif de couplage pour signaux à large bande suivant la revendication 1, caractérisé par le fait que les transistors formant interrupteurs (Tnk), les transistors amont (Tne) et les transistors d'échantillonnage (Tna) sont des transistors à canal n et que les transistors de précharge (Tpi) sont des transistors à canal p.

3. Dispositif de couplage pour signaux à large bande suivant la revendication 1, caractérisé par le fait qu'aussi bien les transistors formant interrupteurs (Tnk), les transistors amont (Tne) et les transistors d'échantillonnage (Tna) ainsi que les transistors de précharge (Tpi) sont des transistors à canal n.

4. Dispositif de couplage pour signaux à large bande suivant l'une des revendications 1 à 3, caractérisé par le fait qu'il est prévu respectivement un transistor d'échantillonnage (Tnaij) pour chaque élément de couplage.

5. Dispositif de couplage pour signaux à large bande suivant l'une des revendications 1 à 3, caractérisé par le fait qu'il est prévu un transistor d'échantillonnage (Tnaj) prévu pour chaque ligne d'entrée de la matrice.

6. Dispositif de couplage pour signaux à large bande suivant l'une des revendications 1 à 3, caractérisé par le fait qu'il est prévu un transistor d'échantillonnage (Tnai) pour chaque ligne de sortie de la matrice.

7. Dispositif de couplage à large bande suivant l'une des revendications 1 à 6, caractérisé par le fait que l'amplificateur différentiel à comportement de bascule possède
   - deux circuits inverseurs C-MOS (Tpb', Tnb'; Tpb", Tnb") couplés selon un couplage croisé,
     - aux deux sorties (ai', ai") duquel une source de potentiel d'alimentation ($U_{DD}$) peut être également raccordée simultanément par l'intermédiaire de deux transistors de commutation (Tp'; Tp") possédant un premier type de canal et commandés dans le même sens par le signal de cadence,
     - et un circuit de commande (C) inséré entre les deux transistors (Tnb'; Tnb") possédant l'autre type de canal des circuits inverseurs et l'autre source de potentiel d'alimentation ($U_{SS}$) et comportant

   - deux autres transistors (Tn'; Tn") du même type, insérés entre ces transistors (Tnb'; Tnb") et la source de potentiel d'alimentation ($U_{SS}$),
   - deux circuits série branchés en parallèle avec deux autres transitors (Tn'; Tn") et formés respectivement par un transistor MOS (Tnz'; Tnz") du même type, commandés par le signal d'entrée et par le signal d'entrée négativé, et un transistor MOS (Tnt'; Tnt") du même type commandé par le signal de cadence,
   - et un transistor (Tn) du même type, qui est inséré entre les deux points de jonction (v'; v") des deux circuits inverseurs C-MOS (Tpb', Tnb'; Tpb", Tnb"), couplés selon un couplage croisé, et le circuit de commande (C) et par l'intermédiaire duquel les deux circuits inverseurs C-MOS couplés selon un couplage croisé peuvent être interconnectés pour former un circuit à bascule bistable.

# FIG 1

# FIG 2

# FIG 3

# FIG 4

# FIG 5

# FIG 6